# EUROPEAN PATENT APPLICATION

(11) **EP 0 581 465 A2**
(43) Date of publication of application: **02.02.1994**
(21) Application number: 93305381.1
(22) Date of filing: 08.07.1993
(51) Int. Cl.: G11C 8/00

(54) **Address transition detection**

(30) Priority: 27.07.1992 KR 1343992
(71) Applicant: SAMSUNG ELECTRONICS CO., LTD., Suwon-city, Kyungki-do 441-373 (KR)
(72) Inventor: Lee, Yun-Sang, Jongro-gu, Seoul (KR); Kim, Young-Rae, Seocho-gu, Seoul (KR)
(74) Representative: Stanley, David William

(57) **Abstract**

A semiconductor memory device has an address buffer for receiving a plurality of external address signals A_{φ} - Aₙ, and an address transition detection circuit comprising a plurality of delay circuits 50 each for delaying an address bit signal LASB for a predetermined time, said address bit signal being generated from said address buffer, a plurality of first means 52 - 56 each for receiving both said address bit signal LASB and the output signal of said delay circuit 50 and thereby sensing one transition state of said address bit signal LSAB from a first level to a second level; a plurality of second means 58 each for receiving both said address bit signal LSAB and a signal passed through at least said delay circuit 50, thereby to sense an opposite transition state of said address bit signal LSAB from said second level to said first level; a plurality of third means 62 each for receiving both output signals of said first and second means 52 - 58 and thereby generating a transition sensing pulse LTP corresponding to said address bit signal LASB; a plurality of detection nodes 301 each having a voltage level which is in accordance with a logic level of said transition sensing pulse LTP; a plurality of fourth means each connected to said detection node 301 to generate a transition detection signal LST, and a plurality of fifth means 64 - 82 each being activated at least after said fourth means 86 has been activated and causing said detection node 301 to be precharged by a control signal φS.

## Description

The present invention relates to address transition detection in semiconductor memory devices.

In most semiconductor memory devices, memory cells therein are selected by an address supplied from externally. Such an address may consist of a plurality of address bit signals and addresses selecting memory cells are established by combinations of the address bit signals. Each of the memory cells is selected by means of alternatively varying the combinations of the address bit signals constituting the address. The variable combinations of the address bit signals are made by converting the logic levels of one or more address bit signals. The transition state of the address bit signals is detected by a means called an address transition detection circuit which is employed within the semiconductor memory device. Generally, an address transition detection circuit (referred to as "ATD" hereinafter) detects transition states of the logic levels of the address bit signals and generates a signal which represents whether the address has been varied by transition of the address bit signals constituting the address.

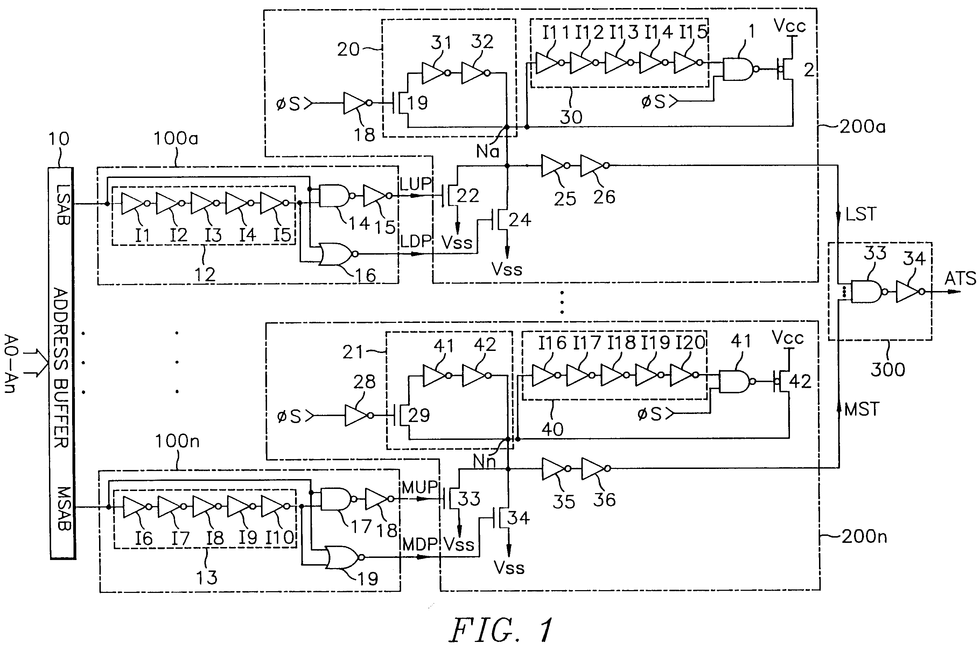

Figure 1 of the accompanying diagrammatic drawings is a circuit diagram showing a conventional ATD. As shown in Figure 1, the conventional ATD is made to respectively detect a transition state of an address bit signal (any one of address bit signals from a least significant address bit signal LSAB to a most significant address bit signal MSAB) which goes from its "low" level to "high" level, and any other transition state of which the address bit signal goes from its "high" level to "low" level. As an example with the least significant address bit signals LSAB, a transition detecting operation is performed by using a LSAB transition pulse generator 100a which receives the LSAB from the address buffer 10 and generates a LSAB rising pulse LUP and a LSAB falling pulse LDP, and a LSAB transition detecting circuit 200a which receives a control signal ΦS, the LSAB rising and falling pulses LUP and LDP and generates an LSAB transition detecting signal LST. Likewise, a transition detecting operation with the most significant address bit signal MSAB can be performed by using a MSAB transition pulse generator 100n which receives the MSAB from the address buffer 10 and generates a MSAB rising pulse MUP and a MSAB falling pulse MDP, and a MSAB transition detecting circuit 200n which receives a control signal ΦS, the MSAB rising and falling pulses MUP and MDP and generates a MSAB transition detecting signal MST. Address transition detecting operations for the other address bit signals are performed as is the case with the LSAB or MSAB.

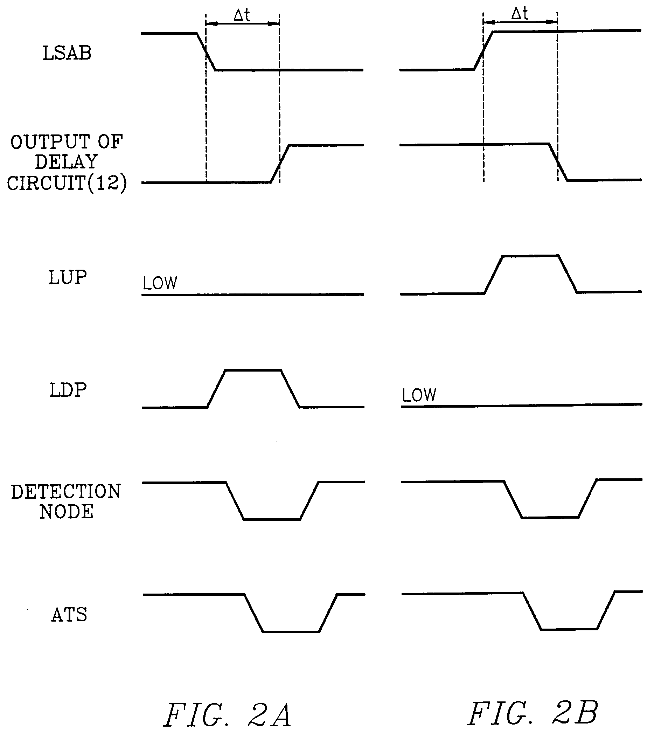

Referring to Figure 2A of the accompanying diagrammatic drawings, a state that the least significant address bit signal LSAB is converted from "high" to "low" will be explained. When the LSAB goes from "high" to "low", the output of the delay circuit 12 is converted from "low" to "high" after being delayed for a predetermined delay time Δt as shown in Figure 2B. Accordingly, inputs to a NAND gate 14 have different state values to each other, so that the LSAB rising pulse LUP maintains "low" level. Meanwhile, the LSAB falling pulse LDP is at "high" level when two inputs to a NOR gate 16 are both at "low" level, i.e., during the predetermined delay time Δt. In other words, if the least significant address bit signal LSAB is converted from "high" to "low", the LSAB falling pulse LDP is generated as a clock having a width which corresponds to the delay time Δt. This pulse LDP turns on an NMOS transistor 24 of the LSAB transition detecting circuit 200a so that the detection node Na connected to the drain side of the NMOS transistor 24 goes to a "low" level as shown in Figure 2A, which in turn allows the LSAB transition detection signal LST to be at "low" level. The logic low state generates an address transition summation signal ATS through an address transition summation circuit 300, corresponding to the transition of the LSAB.

Next, referring to Figure 2B of the accompanying diagrammatic drawings, a state that the LSAB is converted from "low" to "high" will be explained. When the LSAB is converted from "low" to "high" level, according to the operational principle described above, the LSAB rising pulse LUP is generated with a width corresponding to the delay time Δt as shown in Figure 2B. As a result, the address transition summation signal ATS is also generated through the address transition summation circuit 300 as a clock corresponding to the transition of the LSAB.

Also in the cases of when any one of the address bit signals is converted from its "high" level to "low" level or from "low" to "high", transition detecting sequences are the same as described above - that is, both the falling and rising pulses are generated and applied to gates of the NMOS transistors 22 and 24. Hence, in the conventional ATD circuit, different output terminals are required, so as to generate two pulses, namely the falling and rising pulses corresponding to two transition states of the address bit signal. This causes an accumulation range of a semiconductor memory device to be lower.

On the other hand, the ATD should perform a stable operation by preventing its own malfunction with respect to the transition of the address caused by a kind of noise such as short pulses or glitches in an externally input address signal. In order to perform a stable operation, the input trigger levels should be lowered in the order of an inverter 31 of a latch circuit 20, an invertor I11 and an inverter 25. However, it is difficult to adjust the input trigger levels between the inverters 31, I11 and 25 for satisfying the above-mentioned condition.

Furthermore, because the detection node Na is commonly coupled to a drain of a NMOS transistor 19, an output terminal of an inverter 32 of the latch circuit 20, an input terminal of the inverter I11, a drain of a PMOS transistor 2, drains of transistors 22 and 24, and an input terminal of the inverter 25, parasitic junction capacitance thereof is inevitably great, thereby resulting in decreasing detection efficiency.

Preferred embodiments of the present invention aim to provide an improved address transition detection circuit for an integrated semiconductor memory device.

It is another aim to provide an address transition detection circuit capable of performing a stable address transition detecting operation with an easier fabrication method.

It is still another aim to provide a semiconductor memory device having an address transition detection circuit capable of improving an address transition detecting efficiency.

According to one aspect of the present invention, there is provided an address transition detection circuit for use in a semiconductor memory device having an address buffer for receiving a plurality of external address signals, and generating a plurality of address bit signals the circuit comprising a plurality of address transition detection modules, each comprising:
a delay circuit for delaying a respective one of said address bit signals by a predetermined delay time;
a first means for receiving both said address bit signal and an output signal of said delay circuit and thereby sensing one transition state of said address bit signal from a first level to a second level;
a second means for receiving both said address bit signal and a signal which has passed through at least said delay circuit and thereby sensing an other transition state of said address bit signal from said second level to said first level;
a third means for receiving both output signals of said first and second means and thereby generating a transition sensing pulse corresponding to said address bit signal;
a detection node having a voltage level which varies in accordance with a logic level of said transition sensing pulse; and
a fourth means connected to said detection node to generate a transition detection signal.

Preferably, each said module further comprises a fifth means arranged to be activated at least after said fourth means has been activated and causing said detection node to be precharged in response to a control signal.

Preferably, said fourth means comprises an inverter.

Preferably, said fifth means comprises:
a field effect transistor connected between said detection node and a ground voltage terminal and turned off when said control signal is activated;
a latch circuit connected to said detection node and activated at least after said fourth means has been activated; and
a field effect transistor connected between a power source terminal and said detection node and turned on when said control signal is activated.

Preferably, an input trigger level of said inverter is lower than an input trigger level of said latch circuit.

An address transition detection circuit as above may further comprise a sixth means for generating an address transition summation signal which is activated when at least one of said transition detection modules detects a change in the level of the respective address bit signal.

The invention extends to a semiconductor memory device provided with an address transition detection circuit as claimed in any of the preceding aspects of the invention.

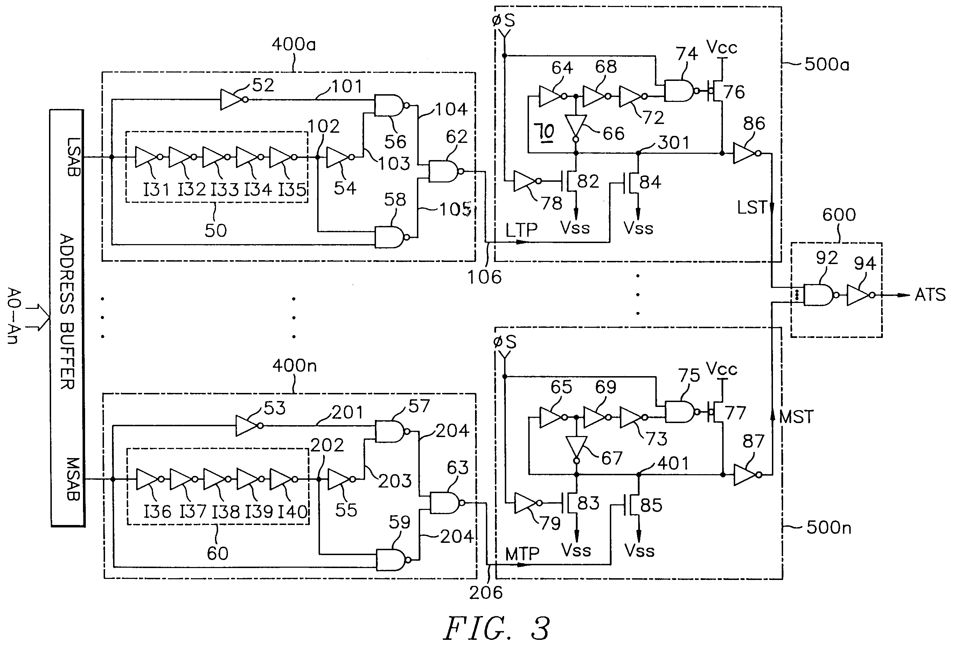

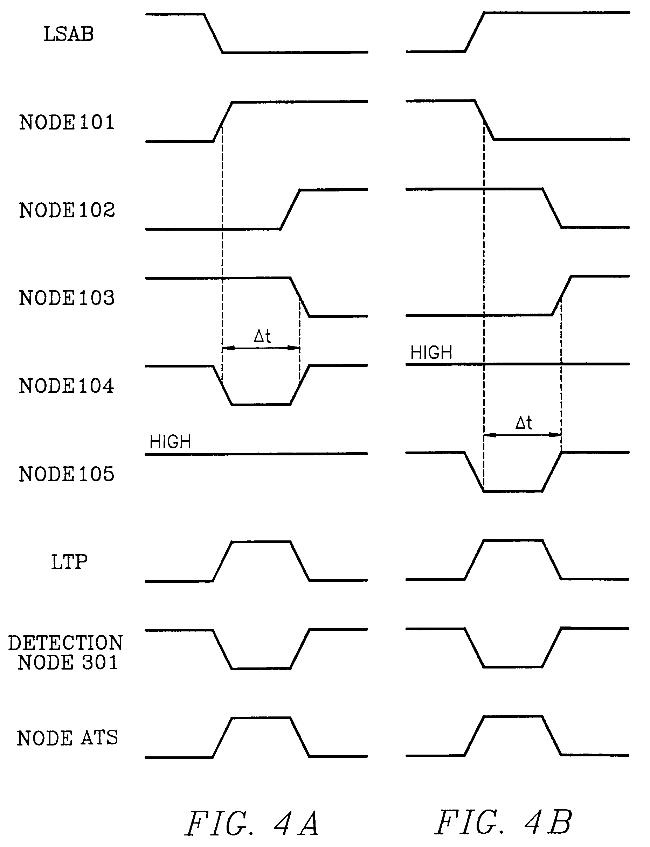

For a better understanding of the invention, and to show how the same may be carried into effect, reference will now be made, by way of example, to Figures 3 and 4 of the accompanying diagrammatic drawings, in which:

Figure 3 is a circuit diagram of one example of an address transition detection circuit according to the present invention; and

Figures 4A and 4B are examples of timing chart diagrams of a circuit as shown in Figure 3, Figure 4A illustrating the case of when an external address signal goes from a "high" level to "low" level, and Figure 4B illustrating the reverse case.

The ATD circuit of Figure 3 comprises a plurality of transition sensing pulse generators 400a - 400n receiving a plurality of address bit signals generated from an address buffer 10 and thereby generating a plurality of transition sensing pulses LTP - MTP corresponding to transition states of the address bit signals, a plurality of transition detecting circuits 500a - 500n respectively receiving the transition sensing pulses LTP - MTP from the transition sensing pulse generators 400a - 400n and generating a plurality of transition detecting signals LST - MST, and a transition summation circuit 600 receiving the transition detecting signals LST - MST from the transition detecting circuit 500a - 500n and generating a transition summation signal ATS. Since all of the transition sensing pulse generators 400a - 400n have the same circuit architecture as each other and all of the transition detecting circuits 500a - 500n have the same circuit architectures as each other, circuit examples of the LSAB transition sensing pulse generator 400a and LSAB transition detecting circuit 500a, which together constitute an address transition detection module for a least significant address bit signal LSAB, will be explained, as an example.

The LSAB transition sensing pulse generator 400a comprises a delay circuit 50 consisting of a delay chain with inverters I31, I32, I33, I34 and I35 which are serially connected so that an input terminal of the inverter I31 is coupled to the LSAB, an inverter 52 having its input terminal coupled to the LSAB, an inverter 54 having its input terminal coupled to an output signal of the delay circuit 50, a first NAND gate 56 receiving output signals from the inverters 52 and 54, a second NAND gate 58 receiving the LSAB from the address buffer 10 and the output signal from the delay circuit 50, and a third NAND gate 62 receiving output signals from the first and second NAND gates 56 and 58 and generating a LSAB transition sensing pulse LTP.

The LSAB transition detecting circuit 500a comprises an NMOS transistor 84 having its gate coupled to receive the LSAB transition sensing pulse LTP and its channel between a detecting node 301 and a ground voltage terminal Vss, an NMOS transistor 82 having its gate coupled to an output terminal of an inverter 78 reversing a logic level of a control signal ΦS and its channel between detecting node 301 and ground voltage terminal Vss, a latch circuit 70 connected to the detecting node 301 and consisting of two inverters 64 and 66, an inverter 68 having its input terminal connected to an output terminal of the inverter 64 of the latch circuit 70, an inverter 72 serially connected to the inverter 68, a NAND gate 74 receiving the control signal ΦS and an output signal of the inverter 72, a PMOS transistor 76 having its gate coupled to the output terminal of the inverter 72 and its channel connected between a power source terminal Vcc and the detecting node 301, and an inverter 86 reversing a logic level on the detecting node 301 to generate an LSAB transition detecting signal LST.

The transition summation circuit 600 comprises a NAND gate 92 receiving the transition detecting signals LST - MST from the transition detecting circuits 500a - 500n and an inverter 94 which generates a transition summation signal ATS from an output signal of the NAND gate 92. The output signal of the NAND gate 92 is activated when at least one of its input signals is converted from "high" to "low" level, or from "low" to "high" level.

Hereinbelow, the transition detecting operation of the circuit of Figure 3, referring to Figure 4A and 4B, will be described in detail.

Figure 4A shows the timing when the LSAB is converted from "high" to "low" level and Figure 4B shows the timing when the LSAB is converted from "low" to "high" level. Firstly, referring to Figure 4A, when the LSAB is converted from "high" level to "low" level, a signal inverted from the LSAB appears on a node 101 at an output terminal of the inverter 52 and a signal delayed from the LSAB by a delay time ΔT comes out on a node 102 at an output terminal of the delay circuit 50. Then, by applying the signal on the node 101 and a signal on a node 103 to input terminals of the first NAND gate 56, a signal on a node 104 at an output terminal of the first NAND gate 56 is generated as a signal with "low" level and a width corresponding to the delay time ΔT. At this time, a signal on node 105 at an output terminal of the second NAND gate 58 stays at "high" level because an input terminal of the second NAND gate 58 receive the signal of "low" level on the node 102. Thus, the LSAB transition sensing pulse LTP on a node 106 at an output terminal of the third NAND gate 62 is generated as "high" level for the duration of the delay time ΔT. This LSAB transition sensing pulse LTP is applied to the gate of the NMOS transistor 84 in the LSAB transition detecting circuit 500a.

The detection node 301 of the LSAB transition detecting circuit 500a is precharged to a "high" level before and after a transition detecting operation. That is, the detection node 301 goes to "low" level when the NMOS transistor 82 is turned on by the control signal ΦS which has been at "low" level until the external address signals A₀-Aₙ are applied to the address buffer 10, and stays at "low" level due to the latch circuit 70. Then, consequently, if the control signal ΦS goes to "high" level, which turns the NMOS transistor 82 off and thereby all input signals of the NAND gate 74 turn to "high" level, the voltage level of the detection node 301 becomes "high" as a precharge level. In the precharged state of the detection node 301, the LSAB transition sensing pulse LTP of "high" level turns the NMOS transistor 84 off to pull down the voltage level of the detection node 301 toward "low" level. An LSAB transition detecting signal LST is generated at "high" level through the inverter 86 and then applied to the input terminal of the NAND gate 92 in the transition summation circuit 600.

Assuming that only the LSAB is converted from its "high" level to "low" level, since other input signals but the LST are all at "low" levels, an output signal of the NAND gate 92 is "low" level and as a result the transition summation signal ATS is generated as "high" level, which informs the internal circuits of the respective semiconductor memory device that an address has been varied. After the delay time ΔT has elapsed, if the LSAB transition sensing pulse LTP returns to its "low" level, the voltage level of the detection node 301 becomes "high" level again, and thereby the transition summation signal ATS returns to its "low" level.

In the other case when the LSAB is converted from "low" level to "high" level, as in Figure 4B, the transition detecting operation is similar to that of Figure 4A.

In each of the transition detecting circuits 500a - 500n, it is preferred that an input trigger level of the inverter 64 of the latch circuit 70 is larger than that of the inverter 86 by the reason that, in order to eliminate detection malfunction, the inverter 64 should be least activated for precharging the detecting node 301 after the inverter 86 has been activated to generate a valid LSAB transition detecting signal LST. An adjustment of the input trigger levels between the inverter 64 and 86 is easier than in the case of a conventional ATD circuit wherein input trigger levels of three inverters should be adjusted in order to ensure a stable transition detecting performance.

Additionally, as the illustrated embodiment of the present invention is not in need of two output terminals or transfer lines for outputting transition sensing pulses such as LUP and LDP in the conventional circuit of Figure 1, the integrity of an ATD circuit can be improved. Moreover, the parasitic junction capacitance at the detection node is reduced by decreasing the packing density in the detection node.

While particular examples of the present invention have been particularly shown and described, it will be understood by those skilled in the art that various changes in form and details may be effected therein without departing from the spirit and scope of the invention as defined by the appended claims.

The term "ground potential" (or like terms such as "ground voltage" or "earth" potential or voltage) is used conveniently in this specification to denote a reference potential. As will be understood by those skilled in the art, although such reference potential may typically be zero potential, it is not essential that it is so, and may be a reference potential other than zero.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. An address transition detection circuit for use in a semiconductor memory device having an address buffer for receiving a plurality of external address signals (A₀ - Aₙ), and generating a plurality of address bit signals (LSAB ... MSAB) the circuit comprising a plurality of address transition detection modules (400, 500), each comprising:
a delay circuit (50) for delaying a respective one of said address bit signals (LSAB) by a predetermined delay time (Δt);
a first means (52 - 56) for receiving both said address bit signal (LSAB) and an output signal of said delay circuit (5a) and thereby sensing one transition state of said address bit signal (LSAB) from a first level to a second level;
a second means (58) for receiving both said address bit signal (LSAB) and a signal which has passed through at least said delay circuit (50) and thereby sensing an other transition state of said address bit signal (LSAB) from said second level to said first level;
a third means (62) for receiving both output signals of said first and second means (52 - 58) and thereby generating a transition sensing pulse (LTP) corresponding to said address bit signal (LSAB);
a detection node (301) having a voltage level which varies in accordance with a logic level of said transition sensing pulse (LTP); and
a fourth means (86) connected to said detection node (301) to generate a transition detection signal (LST).

2. An address transition detection circuit as claimed in claim 1, wherein each said module (400, 500) further comprises a fifth means (64 - 84) arranged to be activated at least after said fourth means (86) has been activated and causing said detection node (301) to be precharged in response to a control signal (φS).

3. An address transition detection circuit as claimed in claim 1 or 2, wherein said fourth means (86) comprises an inverter.

4. An address transition detection circuit as claimed in claim 2 or claims 2 and 3, wherein said fifth means (64 - 84) comprises:
a field effect transistor (82) connected between said detection node (301) and a ground voltage terminal (Vss) and turned off when said control signal (φS) is activated:
a latch circuit (70) connected to said detection node (301) and activated at least after said fourth means (86) has been activated; and
a field effect transistor (76) connected between a power source terminal (Vcc) and said detection node (301) and turned on when said control signal (φS) is activated.

5. An address transition detection circuit as claimed in claim 3 or claims 3 and 4, wherein an input trigger level of said inverter (86) is lower than an input trigger level of said latch circuit (70).

6. An address transition detection circuit as claimed in any of the preceding claims, further comprising a sixth means (600) for generating an address transition summation signal (ATS) which is activated when at least one of said transition detection modules (400, 500) detects a change in the level of the respective address bit signal.

7. A semiconductor memory device provided with an address transition detection circuit as claimed in any of the preceding claims.
